Europäisches Patentamt

European Patent Office

Office européen des brevets

(11) Veröffentlichungsnummer: **0 227 156 B1**

(12) **EUROPÄISCHE PATENTSCHRIFT**

(19)

(45) Veröffentlichungstag der Patentschrift: **10.06.92**

(21) Anmeldenummer: **86202142.5**

(22) Anmeldetag: **02.12.86**

(51) Int. Cl.⁵: **H03H 11/26**, H04N 9/77

(54) **Regelschaltung zum Abgleich einer Laufzeitleitung.**

(30) Priorität: **14.12.85 DE 3544342**

(43) Veröffentlichungstag der Anmeldung:
**01.07.87 Patentblatt 87/27**

(45) Bekanntmachung des Hinweises auf die
Patenterteilung:
**10.06.92 Patentblatt 92/24**

(84) Benannte Vertragsstaaten:
**DE FR GB IT**

(56) Entgegenhaltungen:
**FR-A- 2 535 126**

**IBM TECHNICAL DISCLOSURE BULLETIN,
Band 19, Nr. 8, Januar 1977, Seiten 131,132,
New York, US; W.F. McCARTHY et al.:
"High-frequency analog electronic delay
using phase-locked-loop techniques"**

**ELECTRONICS AND COMMUNICATIONS IN
JAPAN, Band 55-A, Nr. 9, September 1972,
Seiten 30-36, Washington, US; T. YANAGISA-
WA et al.: "Constant-resistance transfer networks using gyrators"**

(73) Patentinhaber: **Philips Patentverwaltung
GmbH**

Wendenstrasse 35 Postfach 10 51 49
W-2000 Hamburg 1(DE)

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**FR GB IT**

(72) Erfinder: **Harlos, Hartmut
Toenns-Wulf-Weg 12
W-2000 Hamburg 65(DE)**
Erfinder: **Juhnke, Klaus
Hohle Eiche 4
W-2084 Rellingen(DE)**
Erfinder: **Kelting, Peter
Heussweg 33
W-2200 Elmshorn(DE)**

(74) Vertreter: **Poddig, Dieter, Dipl.-Ing. et al
Philips Patentverwaltung GmbH Wendenstrasse 35 Postfach 10 51 49
W-2000 Hamburg 1(DE)**

EP 0 227 156 B1

## Beschreibung

Die Erfindung betrifft eine Regelschaltung zum Abgleich einer Laufzeitleitung für einen Fernsehempfänger, die aus in Reihe geschalteten Allpaßgliedern von mindestens 2. Ordnung besteht, deren Induktivitäten durch mit Kapazitäten beschaltete Gyratoren ersetzt sind.

Aus der Valvo-Veröffentlichung "Technische Information 840228" (TDA 4560) ist eine solche Laufzeitleitung bekannt, die in Reihe geschaltete Allpaßglieder 2. Ordnung enthält. Bei Allpaßgliedern hängt nur der Phasengang der Übertragungsfunktion von der Frequenz ab, während der Amplitudengang frequenzunabhängig ist. Ein Allpaßglied ruft für nicht modulierte Signale eine Verzögerung hervor, die die Phasenlaufzeit darstellt. Da für derartige Allpaßglieder, die keine aktiven Bauelemente enthalten, Induktivitäten erforderlich sind und diese nicht auf einem Halbleitersubstrat integriert werden können, ist die Induktivität durch einen mit einer Kapazität beschalteten Gyrator ersetzt worden. Ein Allpaßglied ist dadurch mit Hilfe von Transistoren, Kapazitäten und Widerständen auf einer integrierten Schaltung realisierbar.

Die verwendeten Kapazitäten werden als Sperrschichtkapazitäten integriert. Da der Wert einer Sperrschichtkapazität bekanntlich von der an ihr liegenden Vorspannung abhängt, ist es möglich, einerseits die Verzögerungzeit eines Allpaßgliedes mittels der Vorspannung in einem begrenzten Bereich zu verändern und andererseits die Spannungsabhängigkeit der Kapazitäten zur automatischen Kompensation unerwünschter Einflüsse zu verwenden. Bei der bekannten Schaltungsanordnung kann durch Vergleich eines internen Widerstandes mit einem externen Referenzwiderstand, der einen bestimmten Widerstandswert hat, eine Vorspannung abgeleitet werden, mit der die Werte der Sperrschichtkapazitäten der Allpaßglieder so gesteuert werden, daß die Verzögerungzeit unabhängig von der Dotierung und den geometrischen Strukturabmessungen der integrierten Schaltung, sowie von der Temperatur und der Versorgungsspannung wird. Es hat sich bei der Produktion solcher Laufzeitleitungen jedoch gezeigt, daß so große Streuungen auftreten, daß mit dem externen Referenzwiderstand die Kompensation der unerwünschten Einflüsse nicht vollständig erreicht wird.

Der Erfindung liegt die Aufgabe zugrunde, eine Regelschaltung zum Abgleich einer Laufzeitleitung der eingangs genannten Art so auszubilden, daß die Ausbeute bei einer Realisierung der Laufzeitleitung als integrierte Schaltung vergrößert wird.

Diese Aufgabe wird erfindungsgemäß dadurch gelöst, daß der Eingang der Laufzeitleitung mit einem Umschalter verbunden ist, der diesem Eingang in einer ersten Stellung ein Fernsehsignal und in einer zweiten Stellung das über einen Verstärker geleitete Ausgangssignal der Laufzeitleitung zuführt, daß ein in der zweiten Stellung aus der Laufzeitleitung und dem Verstärker gebildeter Oszillator Teil eines Phasenregelkreises ist, der aus dem Vergleich zwischen einem zeilenfrequenten Signal und dem Ausgangssignal des Verstärkers ein Regelsignal, das während der ersten Stellung des Umschalters gespeichert ist, für die Allpaßglieder erzeugt und damit deren Verzögerungszeit regelt, und daß die zweite Stellung des Umschalters während wenigstens einer Zeile der Vertikalaustastzeit vorliegt.

Es sei erwähnt, daß aus "Radiomentor electronic, Band 37, l966, Nr. 4, Seiten 30l bis 303" eine Zeitfehlerkorrektureinrichtung bekannt ist, die eine abzugleichende Laufzeitleitung enthält. Die Verzögerungszeit der Laufzeitleitung kann mittels Auswahl eines Abgriffes an dieser Leitung eingestellt werden. Jeder Abgriff dieser Laufzeitleitung ist mit jeweils einer nur an diesen Abgriff geschalteten Regelschaltung verbunden, in der das verzögerte Fernsehsignal durchgelassen wird, wenn die zeitliche Koinzidenz zwischen dem Ausgangssignal der Laufzeitleitung und einem Vergleichssignal vorhanden ist. Dieser Abgleich wird zu Beginn jeder Zeile durchgeführt. Die erfindungsgemäße Schaltungsanordnung weist gegenüber der bekannten Einrichtung den Unterschied auf, daß zur Regelung ein die Laufzeitleitung beinhaltender Oszillator verwendet wird, der Bestandteil eines Phasenregelkreises ist, zum Abgleich der Verzögerungszeit der Laufzeitleitung an den Sollwert. Außerdem wird in der bekannten Schaltungsanordnung die Laufzeitleitung nicht durch mit Kapazitäten beschaltete Gyratoren realisiert.

In der erfindungsgemäßen Schaltungsanordnung wird die Verzögerungszeit der einzelnen Allpaßglieder geregelt. Dies geschieht dadurch, daß während der Vertikalaustastzeit (das ist die Zeit, in der der Halbbildwechsel stattfindet) die Laufzeitleitung mit einem Verstärker einen Oszillator bildet, der Teil eines Phasenregelkreises ist. Hierzu ist es nötig, daß der Umschalter in eine zweite Stellung wechselt und somit kein Fernsehsignal an den Eingang der Laufzeitleitung gelangt. Da der Phasenvergleich während der Vertikalaustastzeit vorgenommen wird und dann keine Bildinformation vorliegt, wird auch nicht das sichtbare Bild gestört. Das vom Phasenregelkreis erzeugte Regelsignal wird bis zur folgenden Vertikalaustastzeit, in der der nächste Vergleich erfolgt, gespeichert, damit an den Allpaßgliedern der Laufzeitleitung immer ein Regelsignal anliegt. Im Phasenregelkreis wird während der zweiten Stellung des Umschalters der Vergleich zwischen einem zeilenfrequenten Signal und dem Ausgangssignal des Verstärkers durchgeführt. Dadurch kann die Laufzeitleitung bei allen heute verwendeten Fernsehstandards angewendet werden, da die Verzögerungszeit automatisch an die jeweilige Zeilenfrequenz angepaßt wird.

In einer ersten Weiterbildung der Erfindung ist vorgesehen, daß der Phasenregelkreis einen Frequenzteiler und eine Phasenvergleichsschaltung umfaßt, die entsprechend dem Vergleich zwischen dem zeilenfrequenten Signal und dem über den Frequenzteiler der Phasenvergleichsschaltung zugeführten Ausgangssignal des Verstärkers das Regelsignal erzeugt. Die Frequenz des Ausgangssignals des Frequenzteilers, der die Frequenz des Ausgangssignals des Verstärkers teilt, ist nahezu gleich mit der Zeilenfrequenz. Mit diesem frequenzgeteilten Signal wird in der nachgeschalteten Phasenvergleichsschaltung der Vergleich zwischen diesem Signal und einem aus dem gesamten Fernsehsignal abgetrennten zeilenfrequenten Signal durchgeführt.

In einer weiteren Fortbildung der Erfindung ist vorgesehen, daß die Speicherung des Regelsignals in einem Kondensator erfolgt. Die das Regelsignal erzeugende Phasenvergleichsschaltung und der Kondensator sind so ausgelegt, daß die Phasenvergleichsschaltung in der Vertikalaustastzeit den Kondensator schnell lädt und daß zwischen zwei Vertikalaustastzeiten das im Kondensator gespeicherte Regelsignal weitgehend konstant bleibt.

Für den aus Verstärker und Laufzeitleitung gebildeten Oszillator muß die Schwingbedingung in Bezug auf Amplitude und Phase eingehalten werden. Daher ist vorgesehen, daß der Verstärker eine das Ausgangssignal der Laufzeitleitung invertierende Stufe umfaßt.

Da ein Oszillatorsignal nur während der zweiten Stellung des Umschalters vom Oszillator erzeugt werden soll, ist vorgesehen, daß der Verstärker nur in der zweiten Stellung eingeschaltet ist. Des weiteren ist vorgesehen, daß der Verstärker durch das Einschalten das Oszillatorsignal bei einer vorbestimmten Phasenlage startet. Da schon ein Signal zum Einschalten des Verstärkers zur Verfügung steht, kann auch gleichzeitig dieses Signal zum Start des Oszillatorsignals benutzt werden. Das Einschalten des Verstärkers kann nun mit einem aus den Horizontalimpulsen erzeugten Einschaltimpuls erfolgen.

Nachdem nun das Oszillatorsignal bei einer bestimmten Phasenlage zum Horizontalimpuls startet, kann der Vergleich so vorgenommen werden, daß während des nächsten auf den den Oszillator aktivierenden Horizontalimpulses die Phasenvergleichsschaltung das Ausgangssignal des Frequenzteilers mit einem aus dem Horizontalimpuls gewonnenen Impuls vergleicht.

Anhand der Zeichnungen werden im folgenden Ausführungsbeispiele erläutert. Es zeigen:

Fig. I      ein Prinzipschaltbild eines Allpaßgliedes 2. Ordnung als Grundelement einer Laufzeitleitung,

Fig. 2      ein Ausführungsbeispiel der Erfindung,

Fig. 3      ein detailliertes Ausführungsbeispiel für den in Fig. 2 verwendeten Verstärker, und

Fig. 4      verschiedene in der Schaltungsanordnung nach Fig. 2 verwendete Signale.

In Fig. I ist das Prinzipschaltbild eines Allpaßgliedes 2. Ordnung dargestellt, das aus der Valvo-Veröffentlichung "Technische Information 840228" bekannt ist. Bei Allpaßgliedern hängt nur der Phasengang der Übertragungsfunktion für Sinussignale von der Frequenz ab, während der Amplitudengang frequenzunabhängig ist. Da derartige Allpaßglieder für nicht modulierte Signale eine Verzögerung hervorrufen, die mit der Phasenlaufzeit identisch ist, lassen sich Laufzeitleitungen aus hintereinander geschalteten Allpaßgliedern realisieren, die z.B. dazu dienen, das Helligkeitssignal in einem Fernsehempfänger zu verzögern. Allpaßglieder 2. Ordnung, die nur mit passiven Elementen realisiert werden, benötigen außer Widerständen und Kapazitäten auch Induktivitäten. Damit ein solches Allpaßglied aber vollständig in einer integrierten Schaltung verwendet werden kann, muß die Induktivität mit Hilfe aktiver Bauelemente ersetzt werden.

In der Schaltung nach Fig. I hat man die Induktivität durch einen Gyrator und eine Kapazität nachgebildet. Unter einem Gyrator versteht man ein Zweitor mit der folgenden Eigenschaft: Schließt man das Zweitor auf einer seiner Seiten mit einem Zweipol der Impedanz Z ab, so entsteht auf der anderen Seite des Zweitors eine Impedanz, die sich von I/Z nur um einen positiven konstanten Faktor unterscheidet. Ein mit einer Kapazität ausgangsseitig abgeschlossener Gyrator wirkt also eingangsseitig wie eine Induktivität.

Um zu zeigen, wie der Gyrator in der Schaltung nach Fig. I realisiert ist, sei im folgenden zunächst auf den Aufbau der gesamten Schaltung eingegangen. Das Eingangssignal wird der Basis eines npn-Transistors I zugeführt. Der Kollektor des Transistors I ist mit einer Elektrode eines Kondensators 2 mit einem an Masse angeschlossenen Widerstand 3 und mit der Basis eines npn-Transistors 4 verbunden. Eine weitere Verbindung besteht zwischen dem Kollektor des Transistors 4 und der Basis eines npn-Transistors 5, dessen Kollektor an Masse angeschlossen ist. Eine Elektrode eines Kondensators 6 ist ebenfalls an den Kollektor des Transistors 4 angeschlossen. Der anderen Elektrode des Kondensators 6 wird ebenso wie der zweiten Elektrode des Kondensators 2 ein Regelsignal zugeführt, mit dem es möglich ist, die Verzögerungszeit des Allpaßgliedes einzustellen. Der Emitter des Transistors 5 ist über einen Widerstand 7 mit dem Emitter des Transistors I gekoppelt. Des weiteren sind der Emitter des Transistors I über einen Widerstand 8 und der Emitter des Transistors 4 über einen Widerstand 9 mit dem Emitter eines npn-Transistors I0 verbunden. Die Basis dieses Transistors I0 ist an Masse angeschlossen. Das Ausgangssignal des Allpaßgliedes liegt am Kollektor des Transistors I0 an. Der mit einer Kapazität ausgangsseitig abgeschlossene Gyrator wird mit Hilfe der Transistoren I und 4 und des Kondensators 6 realisiert. Die Resonanzfrequenz dieses Allpaßgliedes wird bestimmt durch die Widerstände 7 und 9 und durch die Kondensatoren 2 und 6. Weitere Informationen zu dem hier dargestellten Allpaßglied 2. Ordnung lassen sich der oben genannten Veröffentlichung entnehmen.

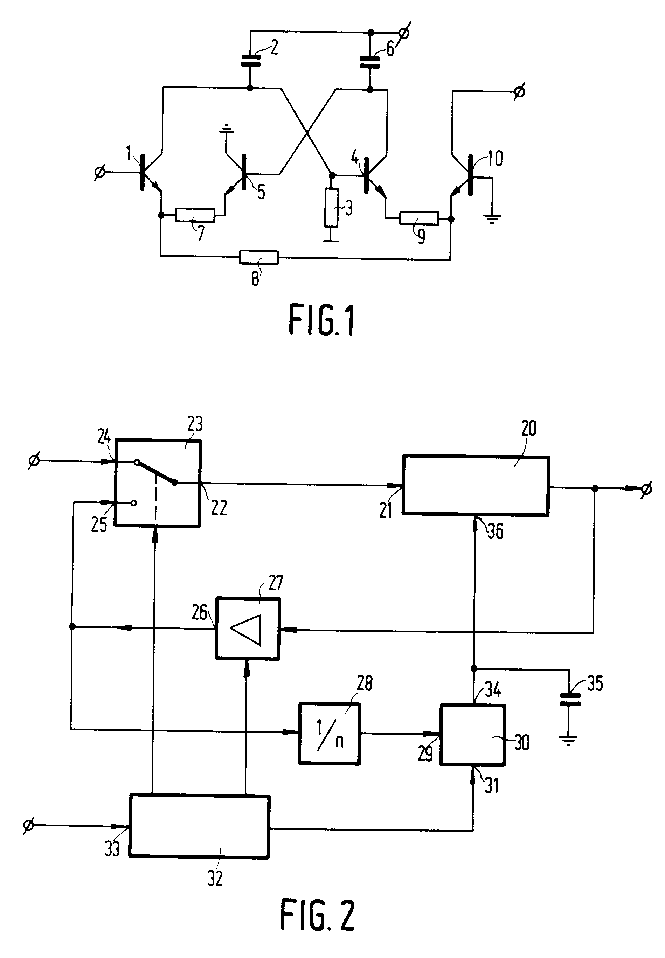

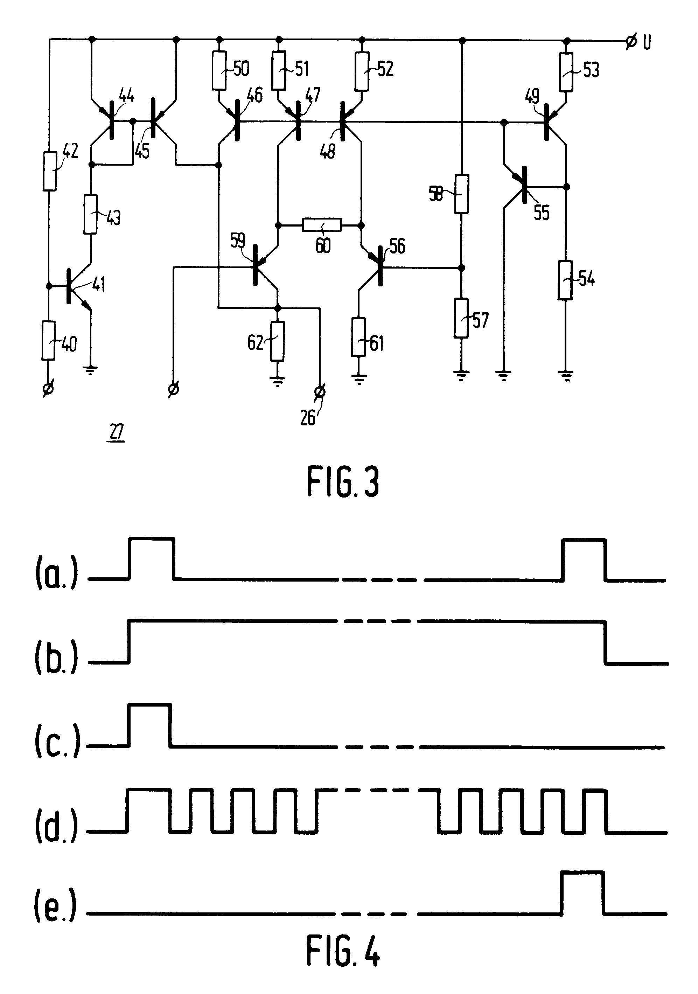

In Fig. 2 ist ein Ausführungsbeispiel der Erfindung beschrieben, das eine Laufzeitleitung 20 enthält, die aus in Reihe geschalteten Allpaßgliedern 2. Ordnung nach Fig. I besteht. Der Eingang 2I der Laufzeitleitung 20 ist mit einem Ausgang 22 eines Umschalters 23 verbunden. Dem Eingang 24 des Umschalters 23 wird z.B. ein Helligkeitssignal zugeführt, das in der Laufzeitleitung verzögert werden soll. Der Eingang 25 des Umschalters 23 ist mit einem Ausgang 26 eines Verstärkers 27 verbunden, der eine invertierende Stufe enthält. In der ersten Stellung des Umschalters 23 verbindet er den Eingang 24 und den Ausgang 22 und in der zweiten Stellung verbindet er den Eingang 25 mit dem Ausgang 22. Das Ausgangssignal der Laufzeitleitung 20 wird dem Verstärker 27 zugeführt.

Das Ausgangssignal des Verstärkers 27 wird auch über einen Frequenzteiler 28 dem Eingang 29 einer Phasenvergleichsschaltung 30 zugeleitet. Dem anderen Eingang 3I der Phasenvergleichsschaltung 30 werden aus den Horizontalimpulsen in einer Steuerschaltung 32 gewonnene Impulse (Referenzsignal) zugeführt. Des weiteren erzeugt die Steuerschaltung 32 aus den Synchronimpulsen, die dem Eingang 33 zugeführt werden, ein Einschaltsignal für den Verstärker 27 und ein Umschaltsignal für den Umschalter 23.

Der Ausgang 34 der Phasenvergleichsschaltung 30 ist mit einem an Masse angeschlossenen Kondensator 35 verbunden. Das von der Phasenvergleichsschaltung 30 erzeugte Regelsignal wird über den Ausgang 34 einem Regelsignaleingang 36 der Laufzeitleitung 20 zugeführt.

Liegt der Umschalter 23 in seiner zweiten Stellung, bilden Verstärker 27 und Laufzeitleitung 20 einen Oszillator. Die Laufzeitleitung 20 dient dabei als Rückkopplungsnetzwerk. Dieser Oszillator ist Teil eines mit dem Frequenzteiler 28 und der Phasenvergleichsschaltung 30 gebildeten Phasenregelkreises zur Regelung der Verzögerungszeit der Laufzeitleitung 20 bzw. der darin enthaltenen Allpaßglieder. Die Regelung der Verzögerungszeit erfolgt während einer oder mehrerer Zeilenperioden innerhalb der Vertikalaustastzeit. In der Vertikalaustastzeit liegt keine Bildinformation vor. Außerdem findet dann der Wechsel zwischen zwei Halbbildern statt. Nachdem der Umschalter in seiner zweiten Stellung liegt, wird auch der Verstärker 27 durch ein von der Steuerschaltung 32 geliefertes Einschaltsignal eingeschaltet und das frequenzgeteilte Ausgangssignal des Verstärkers 27 wird in der Phasenvergleichsschaltung mit einem von der Steuerschaltung 32 aus den Horizontalimpulsen abgeleiteten Referenzsignal verglichen. Entsprechend diesem Vergleich wird die Verzögerungszeit mittels eines Regelsignals in der Laufzeitleitung 20 eingestellt. Da das Regelsignal im Kondensator 35 gespechert wird, liegt am Regelsignaleingang 36 der Laufzeitleitung 20 auch während der Zeit, in der der Umschalter 23 in der ersten Stellung ist, ein konstantes Regelsignal an. Die Regelung der Verzögerungszeit wird nur innerhalb der Vertikalaustastzet vorgenommen. Somit können keine Störungen durch den Regelvorgang auf dem Bildschirm sichtbar werden. Da das Referenzsignal aus einem zeilenfrequenten Signal gewonnen wird, ist eine solche Schaltungsanordnung für alle heute verwendeten Fernsehstandards zu gebrauchen.

Zur Erläuterung der Schwingungserzeugung des aus Verstärker 27 und Laufzeitleitung 20 gebildeten Oszillators und zur Ablaufsteuerung ist in Fig. 3 ein detailliertes Ausführungsbeispiel für den Verstärker 27 dargestellt. Über einen Widerstand 40 wird der Basis eines npn-Transistors 4I, dessen Emitter mit Masse verbunden ist, ein Einschaltsignal zugeführt. Die Basis des Transistors 4I ist über einen Widerstand 42 an eine Speisequelle U angeschlossen. Der Kollektor des Transistors 4I ist über einen Widerstand 43 an einen Stromspiegel angeschlossen, der aus pnp-Transistoren 44 und 45 gebildet wird. Der Kollektor und die Basis des Transistors 44 und die Basis des Transistors 45 sind mit dem Widerstand 43 verbunden und die Emitter der Transistoren 44 und 45 mit der Speisequelle U.

Der Kollektor des Transistors 45 ist mit dem Kollektor eines pnp-Transstors 46 zusammengeschaltet, dessen Basis mit den Basen von pnp-Transistoren 47, 48 und 49 verbunden ist. Der Emitter des Transistors 46 ist über einen Widerstand 50, der Emitter des Transistors 47 über einen Widerstand 5I und der Emitter des Transistors 48 ebenfalls über einen Widerstand 52 an die Speisequelle U angeschlossen. Der Emitter des Transistors 49 ist über einen Widerstand 53 an die Speisequelle angeschlossen und der Kollektor an einen mit Masse verbundenen Widerstand 54. Die Basis des Transistors 49 weist noch eine Verbindung mit dem Emitter eines pnp-Transistors 55 auf, dessen Basis an den Kollektor des Transistors 49 und dessen Kollektor an Masse angeschlossen ist. Mit Hilfe der Transistoren 49 und 55 wird dafür gesorgt, daß die als Stromquellen geschalteten Transistoren 46, 47 und 48 eine entsprechende Basisspannung geliefert bekommen.

Der Kollektor des Stromquellentransistors 48 ist mit dem Emitter eines pnp-Transistors 56 gekoppelt. Die Basis des Transistors 56 ist mit einem aus einem an Masse angeschlossenen Widerstand 57 und einem an die Speisequelle angeschlossenen Widerstand 58 gebildeten Spannungsteiler verbunden. Der Kollektor des Stromquellentransistors 47 ist mit dem Emitter eines pnp-Transistors 59 verbunden, dessen Basis das Eingangssignal zugeführt wird. Die Emitter der beiden Transistoren 56 und 59 sind mit einem Widerstand 60 gekoppelt. Die beiden einen Differenzverstärker bildenden Transistoren 56 und 59 besitzen jeweils Kollektorwiderstände 61 und 62. Es besteht schließlich noch eine Verbindung zwischen dem Kollektor des Transistors 45 und dem Kollektor des Transistors 59. Das Ausgangssignal des Verstärkers 27 kann am Kollektor des Transistors 59 abgenommen werden.

Mit Hilfe der Fig. 4 wird im folgenden die Funktion des Verstärkers nach Fig. 3 näher erläutert und ebenfalls der Ablauf des Regelvorganges näher spezifiziert. Der Umschalter soll nur während einer Zeile in der Vertikalaustastzeit in der zweiten Stellung liegen. Dem Eingang 33 der Steuerschaltung 32 wird z.B. das Synchronsignalgemisch zugeführt, woraus dann in der Steuerschaltung mit einer üblichen Abtrennschaltung die Horizontalimpulse und ein Kennimpuls gewonnen wird, aus dem ersichtlich ist, wann die Vertikalaustastzeit vorliegt. Zur Steuerung und für den Vergleich im Phasenregelkreis werden drei unterschiedliche Impulse benötigt, die die Steuerschaltung 32 erzeugt. In Fig. 4 sind im Diagramm a zwei aufeinanderfolgende Horizontalimpulse dargestellt. In der Steuerschaltung 33 wird daraus das Umschaltsignal für den Umschalter 23 erzeugt, das im Diagramm b dargestellt ist. Des weiteren ist im Diagramm c das Einschaltsignal für den Verstärker aufgezeichnet, das dem ersten Horizontalimpuls entspricht und im Diagramm e das dem Eingang 31 der Vergleichsschaltung 30 zugeführte Vergleichssignal gezeigt, das dem zweiten Horizontalimpuls entspricht. Das positive Einschaltsignal, dargestellt im Diagramm c der Fig. 4 erzeugt am Kollektor des Transistors 59 eine positive Spannung. Dieses Signal wird über den Eingang 21 der Laufzeitleitung 20 zugeführt und um die Verzögerungszeit dieser Leitung verzögert. Nachdem der positive Einschaltimpuls des Verstärkers 27 beendet ist, kann das über die Laufzeitleitung 20 rückgekoppelte Signal, das an der Basis des Transistors 59 anliegt, zum Ausgang 26 des Verstärkers 27 gegeben werden. Da der Transistors 59 das Eingangssignal invertiert, springt das Oszillatorsignal oder das Ausgangssignal des Verstärkers auf ein negativeres Potential. Dieses Signal wird in der Laufzeitleitung 20 wieder um eine Verzögerungszeit verzögert und dann im Verstärker 27 invertiert, so daß der Oszillator eine Frequenz erzeugt, die umgekehrt proportional zur doppelten Verzögerungszeit ist. Das vom Verstärker 27 erzeugte Ausgangssignal ist im Diagramm d der Fig. 4 aufgezeichnet.

Ein Allpaßglied der Laufzeitleitung 20 soll ein Signal um 100 ns verzögern, d.h. die Laufzeit der gesamten Laufzeitleitung 20 beträgt bei 10 verwendeten Allpaßgliedern 1000 ns. Damit der Frequenzteiler 28 die Frequenz des Ausgangssignals des Verstärkers 27 auf 15,625 kHz (das ist die Frequenz der Horizontalimpulse) herunterteilt, muß das Teilerverhältnis gleich 32 sein. Der Frequenzteiler empfängt das Signal vom Kollektor des Transistors 59. Das Ausgangssignal des Frequenzteilers 28 und das Referenzsignal der Steuerschaltung 32, das im Diagramm e der Fig. 4 aufgezeichnet ist, werden in der Phasenvergleichsschaltung 30 in der Phase verglichen und ein Regelsignal entsprechend diesem Phasenvergleich erzeugt. Eine derartige Phasenvergleichsschaltung ist z.B. aus der Zeitschrift "Funkschau", 1976, Heft 7, Seite 257 bis 259 bekannt.

Für die Erzeugung des Oszillatorsignals, dessen Frequenz der Zeilenfrequenz angepaßt wird, ist eine bestimmte Anzahl von Verzögerungsleitungen notwendig. Die Frequenz ist nämlich umgekehrt proportional zur doppelten Verzögerungszeit. Um aber in der ersten Stellung des Umschalters 23 ein Helligkeitssignal eine kürzere oder längere Zeit zu verzögern, kann vorgesehen werden, daß Allpaßglieder abgeschaltet oder zugeschaltet werden.

**Patentansprüche**

1. Regelschaltung zum Abgleich einer Laufzeitleitung (20) für einen Fernsehempfänger, die aus in Reihe geschalteten Allpaßgliedern von mindestens 2. Ordnung besteht, deren Induktivitäten durch mit Kapazitäten beschaltete Gyratoren ersetzt sind,
dadurch gekennzeichnet, daß der Eingang (21) der Laufzeitleitung (20) mit einem Umschalter (23) verbunden ist, der diesem Eingang (21) in einer ersten Stellung ein Fernsehsignal und in einer zweiten Stellung das über einen Verstärker (27) geleitete Ausgangssignal der Laufzeitleitung (20) zuführt, daß ein in der zweiten Stellung aus der Laufzeitleitung (20) und dem Verstärker (27) gebildeter Oszillator Teil eines Phasenregelkreises ist, der aus dem Vergleich zwischen einem zeilenfrequenten Signal und dem Ausgangssignal des Verstärkers (27) ein Regelsignal, das während der ersten Stellung des Umschalters (23) gespeichert ist, für die Allpaßglieder erzeugt und damit deren Verzögerungszeit regelt, und daß die zweite Stellung des Umschalters (23) während wenigstens einer Zeile der Vertikalaustastzeit vorliegt.

2. Regelschaltung zum Abgleich einer Laufzeitleitung für einen Fernsehempfänger nach Anspruch 1,
dadurch gekennzeichnet, daß der Phasenregelkreis einen Frequenzteiler (28) und eine Phasenvergleichsschaltung (30) umfaßt, die entsprechend dem Vergleich zwischen dem zeilenfrequenten Signal und dem über den Frequenzteiler (28) der Phasenvergleichsschaltung (30) zugeführten Ausgangssignal des Verstärkers (27) das Regelsignal erzeugt.

3. Regelschaltung zum Abgleich einer Laufzeitleitung für einen Fernsehempfänger nach einem der vorhergehenden Ansprüche,
dadurch gekennzeichnet, daß die Speicherung des Regelsignals in einem Kondensator (35) erfolgt.

4. Regelschaltung zum Abgleich einer Laufzeitleitung für einen Fernsehempfänger nach einem der vorhergehenden Ansprüche,
dadurch gekennzeichnet, daß der Verstärker (27) eine das Ausgangssignal der Laufzeitleitung (20) invertierende Stufe (59) umfaßt.

5. Regelschaltung zum Abgleich einer Laufzeitleitung für einen Fernsehempfänger nach Anspruch 4,
dadurch gekennzeichnet, daß der Verstärker (27) nur in der zweiten Stellung eingeschaltet ist.

6. Regelschaltung zum Abgleich einer Laufzeitleitung für einen Fernsehempfänger nach Anspruch 5,
dadurch gekennzeichnet, daß der Verstärker (27) durch das Einschalten das Oszillatorsignal bei einer vorbestimmten Phasenlage startet (Fig. 4(d)).

7. Regelschaltung zum Abgleich einer Laufzeitleitung für einen Fernsehempfänger nach Anspruch 6,
dadurch gekennzeichnet, daß das Einschalten mit einem aus dem Horizontalimpuls erzeugten Einschaltimpuls erfolgt (Fig. 4(c)).

8. Regelschaltung zum Abgleich einer Laufzeitleitung für einen Fernsehempfänger nach Anspruch 7,
dadurch gekennzeichnet, daß während des nächsten auf den den Oszillator (20, 27) aktivierenden Horizontalimpulses die Phasenvergleichsschaltung (30) das Ausgangssignal des Frequenzteilers (28) mit einem aus dem Horizontalimpuls gewonnenen Impuls vergleicht.

**Claims**

1. A control circuit for calibrating a delay line (20) for a television receiver, which consists of series-connected all-pass sections of at least 2nd-order, the inductances of which are replaced by gyrators to which capacitances are connected, characterized in that the input (21) of the delay line (20) is connected to a change-over switch (23) which in a first position supplies said input (21) with a television signal and in a second position with the output signal of the delay line (20) which has been passed *via* an amplifier (27), in that an oscillator formed of the delay line (20) and the amplifier (27) in the second position is a part of a phase-locked loop which generates a control signal for the all-pass sections from the comparison between a line-frequency signal and the output signal of the amplifier (27), which control signal, has been stored during the first position of the change-over switch (23) and thus controls the delay time of said sections, and in that the change-over switch (23) is in its second position during at least one line of the vertical blanking period.

2. A control circuit for calibrating a delay line for a television receiver as claimed in Claim 1, characterized in that the phase-locked loop comprises a frequency divider (28) and a phase comparison circuit (30) which generates the control signal in accordance with the comparison between the line-frequency signal and the output signal of the amplifier (27) applied to the phase comparison circuit (30) *via* the frequency divider (28).

3. A control circuit for calibrating a delay line for a television receiver as claimed in any one of the preceding Claims, characterized in that the control signal is stored in a capacitor (35).

4. A control circuit for calibrating a delay line for a television receiver as claimed in any one of the preceding Claims, characterized in that the amplifier (27) comprises a stage (59) which inverts the output signal of the delay line (20).

5. A control circuit for calibrating a delay line for a television receiver as claimed in Claim 4, characterized in that the amplifier (27) is switched on only in the second position.

6. A control circuit for calibrating a delay line for a television receiver as claimed in Claim 5, characterized in that due to the switching on, the amplifier (27) starts the oscillator signal at a predetermined phase position (Fig. 4 (d)).

7. A control circuit for calibrating a delay line for a television receiver as claimed in Claim 6, characterized in that the switching on is effected with a switch-on pulse generated from the horizontal pulse (Fig. 4 (c)).

8. A control circuit for calibrating a delay line for a television receiver as claimed in Claim 7, characterized in that during the next horizontal pulse following the horizontal pulse activating the oscillator (20, 27) the phase comparison circuit (30) compares the output signal of the frequency divider (28) with a pulse obtained from the horizontal pulse.

**Revendications**

1. Circuit de réglage pour l'accord d'une ligne à retard (20) pour un récepteur de télévision, lequel est constitué d'éléments passe-tout qui sont au moins du deuxième ordre, connectés en série, dont les inductances sont remplacées par des girateurs comportant des capacités, caractérisé en ce que l'entrée (21) de la ligne à retard (20) est connectée à un commutateur (23) qui fournit, à cette entrée (21), dans une première position, un signal de télévision et, dans une seconde position, le signal de sortie de la ligne à retard (20) amené par l'intermédiaire d'un amplificateur (27), qu'un oscillateur formé, dans la seconde position, de la ligne à retard (20) et de l'amplificateur (27), fait partie d'un circuit de réglage de phase qui, à partir de la comparaison entre un signal à la fréquence de ligne et le signal de sortie de l'amplificateur (27) produit, pour les éléments passe-tout, un signal de réglage qui est stocké pendant la première position du commutateur (23), et règle ainsi leur temps de retard, et que la seconde position du commutateur (23) est occupée pendant au moins une ligne du temps de suppression de trame.

2. Circuit de réglage pour l'accord d'une ligne à retard pour un récepteur de télévision suivant la revendication 1, caractérisé en ce que le circuit de réglage de phase comprend un diviseur de fréquence (28) et un circuit comparateur de phases (30) qui, en fonction de la comparaison entre le signal à la fréquence de ligne et le signal de sortie de l'amplificateur (27) appliqué au circuit comparateur de phases (30) par l'intermédiaire du diviseur de fréquence (28), produit le signal de réglage.

3. Circuit de réglage pour l'accord d'une ligne à retard pour un récepteur de télévision suivant l'une ou l'autre des revendications précédentes, caractérisé en ce que le stockage du signal de réglage s'effectue dans un condensateur (35).

4. Circuit de réglage pour l'accord d'une ligne à retard pour un récepteur de télévision suivant l'une quelconque des revendications précédentes, caractérisé en ce que l'amplificateur (27) comprend un étage (59) inversant le signal de sortie de la ligne à retard (20).

5. Circuit de réglage pour l'accord d'une ligne à retard pour un récepteur de télévision suivant la revendication 4, caractérisé en ce que l'amplificateur (27) n'est enclenché que dans la seconde position.

6. Circuit de réglage pour l'accord d'une ligne à retard pour un récepteur de télévision suivant la revendication 5, caractérisé en ce que l'amplificateur (27) démarre par l'enclenchement du signal d'osciliateur dans une position de phase prédéterminée [Fig. 4(d)].

7. Circuit de réglage pour l'accord d'une ligne à retard pour un récepteur de télévision suivant la revendication 6, caractérisé en ce que l'enclenchement s'effectue au moyen d'une impulsion d'enclenchement produite à partir de l'impulsion horizontale [Fig. 4(c)].

8. Circuit de réglage pour l'accord d'une ligne à retard pour un récepteur de télévision suivant la revendication 7, caractérisé en ce que pendant l'impulsion horizontale suivante activant l'osciliateur (20, 27), le circuit comparateur de phases (30) compare le signal de sortie du diviseur de fréquence (28) avec une impulsion obtenue à partir de l'impulsion horizontale.

FIG.1

FIG.2

FIG.3

(a.)

(b.)

(c.)

(d.)

(e.)

FIG.4